# EUROPEAN PATENT SPECIFICATION

(11) **EP 3 739 285 B1**
(45) Date of publication and mention of the grant of the patent: **22.03.2023**
(21) Application number: 19214045.7
(22) Date of filing: 06.12.2019
(51) Int. Cl.: F28D 15/02, F28F 1/20, H01L 23/367, H01L 23/40, H01L 23/427, F28F 3/06

(54) **HEAT DISSIPATION DEVICE AND BOARD CARD**
WÄRMEABLEITUNGSVORRICHTUNG UND LEITERPLATTE
DISPOSITIF DE DISSIPATION DE CHALEUR ET CARTE DE CIRCUIT

(30) Priority: 15.05.2019 CN 201910406766
(43) Date of publication of application: 18.11.2020
(73) Proprietor: Cambricon Technologies Corporation Limited, Beijing 100191 (CN)
(72) Inventor: HE, Kun, Beijing 100191 (CN); LAN, Huijun, Beijing 100191 (CN); ZHU, Chongxing, Beijing 100191 (CN); HE, Jun, Beijing 100191 (CN); ZHANG, Zhihang, Beijing 100191 (CN); YE, Kai, Beijing 100191 (CN); CHEN, Deheng, Beijing 100191 (CN); CHEN, Shuai, Beijing 100191 (CN)
(74) Representative: Huang, Liwei

(56) References cited:
- US-A1- 2005 098 300
- US-A1- 2009 145 582
- US-A1- 2009 225 518
- US-A1- 2011 061 847
- US-A1- 2013 014 917
- US-A1- 2013 118 717
- US-A1- 2014 345 830
- US-A1- 2018 088 637
- US-A1- 2018 128 552

## Description

### TECHNICAL FIELD

The present disclosure relates to electronic products, and specifically to a heat dissipation device and a board card.

### BACKGROUND

In recent years, breakthroughs of artificial intelligence have brought dramatic changes to the information industry. Accelerator cards based on ASIC (Application Specific Integrated Circuit) chips and FPGA (Field-Programmable Gate Array) chips have increased the speed of data collection, data processing and classification forecasting and have reduced the computing time by orders of magnitude through artificial intelligence algorithms and, especially, through deep learning algorithms.

This requires an increase in hardware computing power, which, however, may cause an increase in the power consumption of a board card, and consequently an increase in the heat generated by the board card. It is urgent to solve the problem of board card heat dissipation.

Existing heat dissipation devices dissipate heat mainly by heat dissipation fins. In the use of the heat dissipation fins, the contact surface between an electronic element and the heat dissipation fins is generally coated with thermally conductive silicone grease, which enables the heat emitted by the electronic element to be transferred effectively to the heat dissipation fins and then dispersed in the ambient air through the heat dissipation fins. However, such heat dissipation device has low heat dissipation efficiency, and it is hard to meet the requirement of heat dissipation of the board card that causes large power consumption.

For example, US 2013/014917 A1 discloses a heat pipe-attached heat sink with bottom radiation fins. In the heat sink, the layout direction of heat pipes and the layout direction of radiation fins are not the same but orthogonal to each other. Therefore, it is impossible to locate radiation fins between the plurality of heat pipes, and it is impossible to achieve the self-localization of heat pipes and the improved heat dissipation efficiency.

### SUMMARY

In view of this, the present disclosure provides a heat dissipation device and a board card, which have higher heat dissipation efficiency. Moreover, the heat dissipation device can do self-localization and thus has high assembling efficiency.

The invention is set out in the appended set of claims.

In the first embodiment, the present invention provides a heat dissipation device which includes:
a fin group including a plurality of heat dissipation fins that form a whole structure; and
a heat pipe group including a plurality of heat pipe, where the fin group is substantially located on one side of the heat pipe group in a first direction, the fin group contacts the heat pipe group in the first direction, the heat dissipation fins include a first heat dissipation fin that contacts at least one of the plurality of heat pipes in a second direction so as to localize at least one of the plurality of heat pipes in the second direction,
the plurality of heat pipes are arranged parallelly in the second direction, and the plurality of heat dissipation fins are arranged parallelly in the second direction.

Second embodiment: in the first embodiment, the first heat dissipation fin may include a first fin body and a first fin inner edgefold. The first fin body may contact the heat pipe(s) in the second direction, the first fin inner edgefold may protrude angularly from the first fin body, and the first fin inner edgefold may contact the heat pipe(s) on one side of the heat pipe(s) in the first direction.

Third embodiment: in the second embodiment, the first fin inner edgefold may be formed on part of the first heat dissipation fin in a length direction of the heat pipe(s).

Forth embodiment: in the second or third embodiment, the first fin inner edgefold may contact adjacent heat dissipation fin of the fin group.

Fifth embodiment: in one of the second to forth embodiments, the first heat dissipation fin may further include a first fin outer edgefold. The first fin outer edgefold and the first fin inner edgefold may be located at two ends of the first fin body in the first direction.

Sixth embodiment: in one of the first to fifth embodiments, the heat dissipation fins may further include a second heat dissipation fin. The second heat dissipation fin and the first heat dissipation fin may form a whole structure, and the second heat dissipation fin may contact the heat pipe(s) on one side of the heat pipe(s) in the first direction.

Seventh embodiment: in the sixth embodiment, the second heat dissipation fin may include a second fin body and a second fin inner edgefold. The second fin inner edgefold may be bent from the second fin body and may contact the heat pipe(s) in the first direction.

Eighth embodiment: in the seventh embodiment, the second fin inner edgefold may contact adjacent heat dissipation fin in the fin group.

Ninth embodiment: in the seventh or eighth embodiment, the second heat dissipation fin may further include a second fin outer edgefold. The second fin outer edgefold and the second fin inner edgefold may be located at two ends of the second fin body in the first direction.

Tenth embodiment: in one of the first to ninth embodiments, the heat pipe(s) may be a flattened heat pipe(s), and the flattening direction of the flattened heat pipe(s) may be the first direction.

Eleventh embodiment: in one of the first to tenth embodiments, the heat dissipation device may further include a metal heat dissipation plate. The metal heat dissipation plate may be located on the other side of the heat pipe group in the first direction, and the metal heat dissipation plate may contact the heat pipe(s).

Twelfth embodiment: in the eleventh embodiment, the heat dissipation fins, the heat pipe group and the metal heat dissipation plate may be joined together by reflow soldering.

The present invention further provides a board card which includes the heat dissipation device in any one of the above embodiments.

The heat dissipation device and the board card of the present invention may have the following technical effects:
in the heat dissipation device of the present disclosure, the heat pipe(s) may receive heat and distribute the heat rapidly, and transfer the heat to the fin group. The fin group may have large heat dissipation area and thus can dissipate the heat into the air rapidly. In assembling of the heat dissipation device, relative positions of the first heat dissipation fin and the heat pipe(s) can be designed properly to obtain expected locating effect. In this way, the locating fixtures may be saved, and the assembling efficiency may be improved.

### BRIEF DESCRIPTION OF THE DRAWINGS

Fig. 1 is a side view of a board card of the present invention according to an embodiment, showing that a heat dissipation device, a chip, and a printed circuit board (PCB) are installed together.
Fig. 2 is a three-dimensional structure diagram of a fin group of the heat dissipation device as shown in Fig. 1.
Fig. 3 is a three-dimensional structure diagram of the fin group from another angle of viewpoint of the heat dissipation device as shown in Fig. 1.
Fig. 4 is a three-dimensional structure diagram of a first heat dissipation fin of the heat dissipation device as shown in Fig. 1.
Fig. 5 is a three-dimensional structure diagram of a second heat dissipation fin of the heat dissipation device as shown in Fig. 1.
Fig. 6 is a three-dimensional structure diagram of a heat pipe of the heat dissipation device as shown in Fig. 1.
Fig. 7 is a three-dimensional structure diagram of a first heat dissipation fin of a board card according to another embodiment.
Fig. 8 is a three-dimensional structure diagram of a first heat dissipation fin of a board card according to another embodiment.

Description of reference signs:
1 PCB;
2 chip;
3 screw;
9 heat dissipation device, 90 fin group, 910 second heat dissipation fin, 911 second fin body, 912 second fin inner edgefold, 913 second fin outer edgefold, 920 first heat dissipation fin, 921 first fin body, 9211 first body portion, 9212 second body portion, 922 first fin inner edgefold, 923 first fin outer edgefold, 95 metal heat dissipation plate, 960 heat pipe group, 96 heat pipe, 961 main pipe wall, 962 side pipe wall;
T thickness direction, L layout direction.

### DETAILED DESCRIPTION OF THE EMBODIMENTS

The exemplary embodiments of the present invention will be described referring to the drawings. It should be understood that the description is intended only to teach a person skilled in the art how the present disclosure is implemented but is not intended to show all practicable means of the present invention or to limit the scope of the appendet claims.

The present invention provides a heat dissipation device and a board card having the heat dissipation device. The heat dissipation device may be installed in the board card to release the heat generated by a heat-generating device (such as a chip) on the board card.

The heat dissipation device can facilitate heat pipe self-localization in a predetermined direction, thus requiring no special locating fixtures, simplifying the joining procedures, and increasing the contact area between a heat dissipation fin and a heat pipe. In this way, the heat dissipation efficiency may be improved.

The technical solutions of the present disclosure will be detailedly described below.

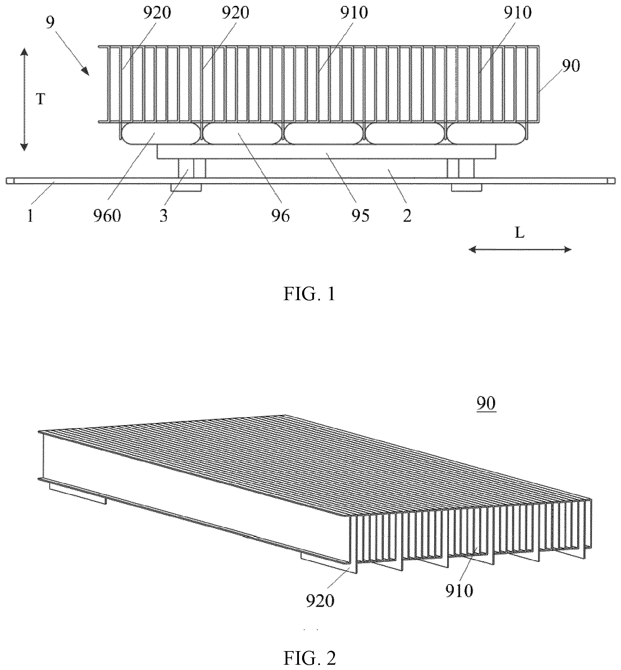

As shown in Fig. 1 to Fig. 3, the heat dissipation device 9 may include a fin group 90, a heat pipe group 960, and a metal dissipation plate 95 that are in contact successively. The heat pipe group 960 may include a plurality of heat pipes 96 arranged in parallel, the fin group 90 may include a plurality of heat dissipation fins arranged in parallel, and a layout direction L (a second direction) of the plurality of heat pipes 96 is the same as the layout direction L of the plurality of heat dissipation fins. The plurality of heat pipes 96 may extend along a straight line, the heat dissipation fins as a whole may extend in a plane, and the extension direction of plurality of the heat pipes 96 may be parallel to the plane where the plurality of heat dissipation fins are located.

It should be emphasized that in other embodiments, the heat dissipation device 9 may not include the metal dissipation plate 95.

In the extension direction of the plurality of heat pipes 96, the plurality of heat pipes 96 and the plurality of heat dissipation fins may have the same length. The plurality of heat pipes 96 may have a high heat transfer efficiency from one end of the extension direction to the other end. This may help to rapidly transfer heat from one end of each of the plurality of the heat dissipation fins to the other end.

In the present disclosure, the plurality of heat pipes 96 may be flattened pipes, and a flattening direction of the plurality of heat pipes 96 may be a thickness direction T (a first direction) of the plurality of heat pipes 96. The fin group 90, the heat pipe group 960, and the metal heat dissipation plate 95 may be arranged in the thickness direction T of the plurality of heat pipes 96. In this way, the heat can be transferred from the metal heat dissipation plate 95 to the heat pipe group 960 and then to the fin group 90 in the thickness direction T of the plurality of heat pipes 96.

It should be understood that "one side of the heat pipe group 960" and "one side of the heat pipe(s) 96" refer to one side of the heat pipe(s) 96 in the thickness direction T, and "the other side of the heat pipe group 960" and "the other side of the heat pipe(s) 96" refer to the other side of the heat pipe(s) 96 in the thickness direction T.

As shown in Fig. 1, the fin group 90 may be located on one side of the heat pipe group 960, and the metal heat dissipation plate 95 may be located on the other side of the heat pipe group 960. The metal heat dissipation plate 95 may be located on one side of a chip 2, and PCB 1 may be located on other side of the chip 2. The chip 2, the metal heat dissipation plate 95, the heat pipe group 960 and the fin group 90 may be in contact successively.

The plurality of heat pipes 96 may be only arranged on a single side of the fin group 90 in the thickness direction T, thus reducing the installation space of the heat pipe group 90, enabling the heat dissipation device to have a small size in the thickness direction T, and facilitating miniaturization of products.

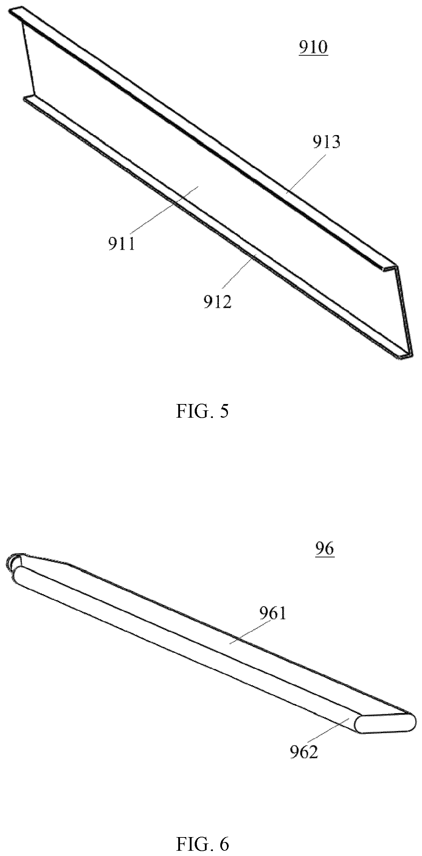

As shown in Fig. 1 and Fig. 6, each of the plurality of heat pipes 96 has an oblong-shaped cross section. The thickness direction T of the plurality of heat pipes 96 is the direction where in a minor axis of the cross section is located, and the layout direction L of the plurality of heat pipes 96 is the direction where a major axis is located.

Each of the plurality of heat pipes 96 is a flattened heat pipe and thus includes main pipe walls 961 and side pipe walls 962. The main pipe walls 961 refer to pipe walls on one side and the other side of the plurality of heat pipes 96, and the side pipe walls 962 are connected to the two main pipe walls (an upper pipe wall and a lower pipe wall) 961. One heat pipe 96 may have two main pipe walls 961 and two side pipe walls 962, and the two main pipe walls 961 and the two side pipe walls 962 may extend along the length direction of the heat pipe 96.

The main pipe walls 961 may have a plane shape, and the side pipe walls 962 may have an arcuate shape. For example, the plurality of heat pipes 96 may be shaped by pressing or flattening in opposite directions from two sides of an axis of a cylindrical heat pipe. In this way, the main pipe walls 961 of a plane shape are formed on two opposite sides that are perpendicular to the axis.

The main pipe wall 961 on the other side of the plurality of heat pipes 96 may contact a surface of the metal heat dissipation plate 95. Since the plurality of heat pipes 96 and the metal heat dissipation plate 95 have a large contact area, the heat of the metal heat dissipation plate 95 can be quickly transferred to the plurality of heat pipes 96.

As shown in Figs. 1 to 3, a plurality of second heat dissipation fins 910 and a plurality of first heat dissipation fins 920 may be connected together and form the fin group 90.

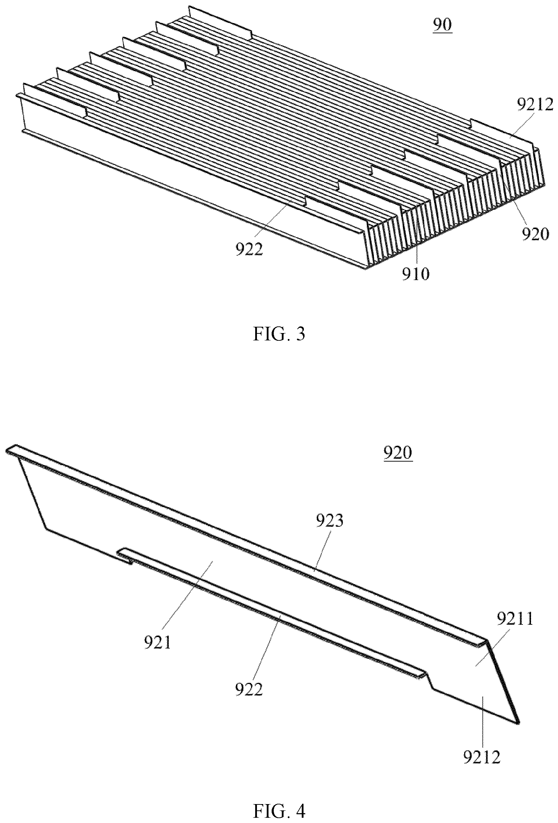

As shown in Fig. 4, a first heat dissipation fin 920 may include a first fin body 921, a first fin inner edgefold 922, and a first fin outer edgefold 923. The first fin body 921 may extend in a plane perpendicular to the layout direction L of the plurality of heat dissipation fins (parallel to the thickness direction T). The first fin inner edgefold 922 and the first fin outer edgefold 923 may be located at two ends of the first heat dissipation fin 920 in the thickness direction T of the heat pipes 96. Specifically, the first fin inner edgefold 922 and the first fin outer edgefold 923 may extend in a direction perpendicular to the first fin body 921. The first fin body 921 may include a first body portion 9211 and a second body portion 9212, and the second body portion 9212 may extend in the thickness direction T of the plurality of heat pipes 96 from the first body portion 9211 to the plurality of heat pipes 96.

As shown in Fig. 5, a second heat dissipation fin 910 may have a second fin body 911, a second fin inner edgefold 912, and a second fin outer edgefold 913.

The second fin body 911 may extend in the plane perpendicular to the layout direction L of the plurality of heat dissipation fins (parallel to the thickness direction T). The second fin inner edgefold 912 and the second fin outer edgefold 913 may be bent from two opposite edges of the second fin body 911 in the thickness direction T. Specifically, the second fin inner edgefold 912 and the second fin outer edgefold 913 may extend in a direction perpendicular to the second fin body 911.

The plurality of second heat dissipation fins 910 may contact sides of the plurality of heat pipes 96 in the thickness direction T so as to receive heat from the plurality of heat pipes 96. Specifically, a plurality of second fin inner edgefolds 912 may wholly contact the sides of the plurality of heat pipes 96 in the thickness direction T, or may partly contact the sides of the plurality of heat pipes 96 in the thickness direction T.

In the embodiment, the second fin inner edgefolds 912 of the plurality of second heat dissipation fins 910 may contact surfaces of the plurality of heat pipes 96. It should be understood that in some embodiments, the second fin inner edgefold 912 of only one of the second heat dissipation fins 910 may contact the surface of the plurality of heat pipes 96.

Solder paste may be coated between the fin group 90 and the heat pipe group 960 and coated between the heat pipe group 960 and the metal heat dissipation plate 95. The fin group 90, the heat pipe group 960 and the metal heat dissipation plate 95 may be joined together by reflow soldering.

Molten solder paste can be filled in a gap between the side pipe walls 962 of two adjacent heat pipes 96. For connection of the first heat dissipation fin 920 and the heat pipes 96, the solder paste may contact both of the second body portion 9212 and the side pipe walls 962.

As shown in Fig. 2 and Fig. 3, the plurality of second heat dissipation fins 910 and one first heat dissipation fin 920 may be arranged alternatively and connected to form the fin group 90. The first fin inner edgefold 922 and the first fin outer edgefold 923 of the first heat dissipation fin 920 between two heat dissipation fins may contact adjacent heat dissipation fins, such as second fin bodies 911 of adjacent second heat dissipation fins 910, or first fin bodies 921 of adjacent first heat dissipation fins 920.

The first fin inner edgefold 922 may contact a side of the plurality of heat pipes 96 in the thickness direction T so that it can receive heat of the plurality of heat pipes 96.

The first fin inner edgefold 922 may be connected with the second fin inner edgefold 912 to form a plane. The first fin inner edgefold 922 and the second fin inner edgefold 912 may both contact the main pipe wall 961 on one side of the plurality of heat pipes 96.

In this way, the heat dissipation fins can contact the sides of the heat pipes 96 in the thickness direction T in a surface-to-surface contact manner. Since the heat pipes 96 and the heat dissipation fins have a large contact area, the heat absorbed by the heat pipes 96 can be quickly transferred to the heat dissipation fins.

As shown in Fig. 1 and Fig. 4, in the thickness direction T of the heat pipes 96, the first body portion 9211 of the first heat dissipation fin 920 is located within a span of the second heat dissipation fin 910, and the second body portion 9212 of the first heat dissipation fin 920 is located within a span of the heat pipes 96.

It should be understood that a span of a component in a direction refers to space that the component spans in the direction.

The heat dissipation device 9 may include some first heat dissipation fins 920, each of which may be located between two adjacent second heat dissipation fins 910. The first body portion 9211 may be located between two adjacent second fin bodies 911, and the second body portion 9212 may be located between two adjacent heat pipes 96.

Two opposite main surfaces of each of the second body portions 9212 of these first heat dissipation fins 920 may contact side pipe walls 962 of two adjacent heat pipes 96. In this way, the heat pipes 96 may transfer heat to the heat dissipation fins not only in the thickness direction T but also in the layout direction L by the second body portions 9212, thus increasing the contact area of heat transfer of the heat dissipation device 9. In addition, the heat dissipation device 9 can facilitate self-localization of the heat pipes 96 in the layout direction L by the second body portions 9212 of the first heat dissipation fins 920, thus requiring no locating fixtures and simplifying installation procedures before joining.

It should be understood that plate-shaped main surfaces refer to surfaces perpendicular to the thickness direction.

In some embodiments, the number of and positional relationship of the first heat dissipation fins 920 and the second heat dissipation fins 910 may be adjusted according to parameters of the heat pipes 96, such as number, size and space.

For example, the number of the first heat dissipation fins 920 and the second heat dissipation fins 910 may be set flexibly. For example, one second heat dissipation fin 910 and one first heat dissipation fin 920 may be arranged alternatively, or one second heat dissipation fin 910 and a plurality of first heat dissipation fins 920 may be arranged alternatively, or a plurality of second heat dissipation fins 910 and a plurality of first heat dissipation fins 920 may be arranged alternatively, or only first heat dissipation fins 920 may be arranged but no second heat dissipation fin 910 is arranged.

The heat dissipation device 9 may further include some first heat dissipation fins 920 that contact the side pipe walls 962 of the heat pipes 96 at one end and/or the other end of the heat pipe group 960, where only one main surface of each of the second body portions 9212 contacts the side pipe walls 962 of the heat pipes 96 at one end and/or the other end of the heat pipe group 960.

The number of such first heat dissipation fins 920 may be two, so that the first heat dissipation fins 920 can contact two heat pipes 96 at both ends of the heat pipe group 960.

Such first heat dissipation fins 920 may be heat dissipation fins located at the outermost end of fin group 90 in the layout direction L. In other words, these first heat dissipation fins 920 may be at the outermost end in the layout direction L, and the fin group 90 may not include any other heat dissipation fins. In other words, the heat pipe group 960 and the fin group 90 have roughly the same length.

In this way, an installation space of the heat pipes 96 may be formed, in the layout direction L, between the second body portions 9212 of every two first heat dissipation fins 920. The heat pipes 96 can be installed in the installation space and carry out self-localization. In addition, this can avoid waste of the heat dissipation fins and the heat pipes 96.

One first heat dissipation fin 920 may have two second body portions 9212, and the two second body portions 9212 may be located at both ends of the first fin body 921 in the length direction of the heat pipes 96. The first fin inner edgefold 922 may be formed on part of the first heat dissipation fin 920 in the length direction of the heat pipes 96. For example, the first fin inner edgefold 922 may be formed on the two second body portions 9212 in the length direction of the heat pipes 96.

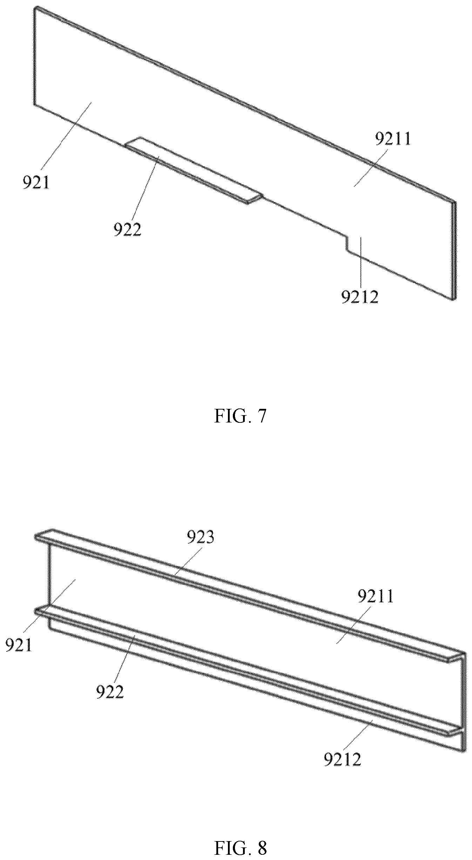

Specifically, in this embodiment, the first fin inner edgefold 922 may extend from one second body portion 9212 to the other second body portion 9212 and contact the surface of the main pipe wall 961 on one side of the heat pipes 96. Or, as shown in Fig. 7, in some embodiments, the first fin inner edgefold 922 may extend between part of the two second body portions 9212.

In some embodiments, a first heat dissipation fin 920 may have three or more second body portions 9212, and the first fin inner edgefold 922 may be formed between every two second body portions 9212; or, a first heat dissipation fin 920 may have a second body portion 9212.

The plurality of heat dissipation fins may form the fin group 90 in several ways, such as fastening (by providing a fastening portion on each of the heat dissipation fins), soldering, or the like, that are commonly seen in the prior art.

All of cross sections of the second heat dissipation fin 910 with the fastening portion removed have the same shape, such as a "U" shape or an "L" shape.

In the heat dissipation device 9 provided in the present disclosure, heat of the chip 2 is transferred to the metal heat dissipation plate 95. Since the metal heat dissipation plate 95 has a high thermal conductivity, the heat can be quickly transferred to the heat pipes 96. After the heat pipes 96 receive the heat from the metal heat dissipation plate 95, the heat is distributed rapidly and transferred to the fin group 90. The fin group 90 has a large heat dissipation area, so the heat can be quickly dissipated into the air.

In addition to distributing the heat, the metal heat dissipation plate 95 can support the heat pipes 96 and heat dissipation fins and ensure flatness of the contact area between the heat dissipation device 9 and the chip 2.

The first heat dissipation fins 920 can contact the heat pipes 96 in the layout direction L so as to locate the heat pipes. Therefore, the heat dissipation device 9 may be assembled by just abutting the heat pipes 96 on the second body portions 9212 of the first heat dissipation fins 920. In this way, no locating fixtures are required, and the assembling efficiency can be greatly improved.

The heat dissipation fins installed between two heat pipes 96 may contact the heat pipes 96 through part of the bodies of the fins extending along the thickness direction T of the heat pipes 96, thereby reducing the number of heat dissipation fins that do not contact the heat pipes 96, or avoiding the case that the heat dissipation fins do not contact the heat pipes 96. Therefore, inefficient heat dissipation on both sides of each of the heat pipes 96 can be reduced or avoided, the contact area between the heat pipes 96 and the heat dissipation fins can be increased, and the heat transfer efficiency of the heat dissipation device 9 can be improved.

The heat dissipation efficiency of the heat dissipation device may be higher if the first fin inner edgefold 922 and the second body portions 9212 of each of the first heat dissipation fins 920 all contact the heat pipes 96. In other words, the heat dissipation efficiency of the heat dissipation device may be higher if the main pipe wall 961 and the side pipe walls 962 of each of the heat pipes 96 all contact the heat dissipation fins.

In the above embodiments, the heat dissipation fins of the fin group 90 are arranged separately, so the heat dissipation fins can be added or removed to form fin groups 90 of different sizes for adapting to board cards having varied heat dissipation requirements.

It should be understood that except for part of the bodies (the second body portions 9212) of the first dissipation fins 920 that contact the heat pipes 96 in the layout direction L, in the fin group 90, the rest of parts of the heat dissipation fins may be arranged on one side of the fin group 960 in the thickness direction T. Thus the fin group 90 can wholly contact the heat pipe group 960 in the thickness direction T.

It should be understood that the present disclosure takes the thickness direction T as the first direction and takes the layout direction L as the second direction. However, the first direction and the second direction may vary in other cases within the idea of the disclosure.

As shown in Fig. 1, the board card provided in the present disclosure may include the above-mentioned heat dissipation device 9. The heat dissipation device 9 can be installed on PCB 1 by screwing. For example, screws 3 may be connected between the PCB 1 and the metal heat dissipation plate 95 to ensure close contact between the heat dissipation device and the PCB 1.

The chip provided in the present disclosure may be an AI accelerating card, a sound card, a display card, a graphics card, or the like.

It should be understood that the embodiments are only examples, but are not limited to the present disclosure. A person skilled in the art may make various modifications or variations within the range of the present disclosure.
(1) The metal heat dissipation plate 95 may be an aluminum plate or a copper plate.
(2) The heat pipes 96 may have an oblong cross section after being flattened. The "oblong" shape mentioned in the present disclosure may include a standard oblong shape and a shape similar to the standard oblong shape as long as planar main pipe walls 961 are formed on two opposite sides of the heat pipes 96 perpendicular to the length direction.
(3) It should be understood that the "plurality" in the present disclosure refers to at least two, including two and more than two.
(4) In some embodiments, only one heat pipe may be provided, or a U-shaped heat pipe may be provided.
(5) In some embodiments, the fin group 90 may be a whole structure. For example, the fin group 90 may include a substrate and a plurality of heat dissipation fins extending along a direction perpendicular to the substrate, the plurality of heat dissipation fins and the substrate may be integrally connected, and the plurality of heat dissipation fins may contact each other by the substrate.
(6) In some embodiments, the heat dissipation 9 and the PCB 1 may be indirectly connected by an adaptor. The adaptor may be fixed on the heat dissipation device 9 by soldering or the like, and connected to the PCB 1, for example, by the screws 3.
(7) In some embodiments, the first heat dissipation fin 920 may not include the first fin inner edgefold 922, and the complete second body portion 9212 may extend from the first body portion 9211; or as shown in Fig. 8, the first fin inner edgefold 922 may be formed on the complete first heat dissipation fin 920 in the length direction of the plurality of heat pipes 96.
(8) In some embodiments, the plurality of heat dissipation fins may not have outer edgefolds.
(9) The "contact" in the present disclosure may be direct contact or indirect contact. The indirect contact may include contact through heat conduction materials, such as heat conduction silicone grease, heat conduction gel, or the like.
(10) It should be understood that the first fin inner edgefold 922 may protrude angularly from the first fin body 921. The first fin inner edgefold 922 may be perpendicular or not perpendicular to the first fin body 921; the first fin inner edgefold 922 and the first fin body 921 may be integrally connected or separately formed.

## Claims

1. A heat dissipation device, comprising:
a fin group (90) including a plurality of heat dissipation fins that form a whole structure; and
a heat pipe group (960) including a plurality of heat pipes (96),
wherein the fin group (90) is substantially located on one side of the heat pipe group (960) in a first direction, the fin group (90) contacts the heat pipe group (960) in the first direction, the heat dissipation fins include a first heat dissipation fin (920) that contacts at least one of the plurality of heat pipes (96) in a second direction so as to locate at least one of the plurality of heat pipes (96) in the second direction,
**characterized in that**
the plurality of heat pipes are arranged parallelly in the second direction, and the plurality of heat dissipation fins are arranged parallelly in the second direction.

2. The heat dissipation device of claim 1, wherein the first heat dissipation fin (920) includes a first fin body (921) and a first fin inner edgefold (922), wherein the first fin body (921) contacts the heat pipe(s) (96) in the second direction, the first fin inner edgefold (922) protrudes angularly from the first fin body (921), and the first fin inner edgefold (922) contacts the heat pipe(s) (96) on one side of the heat pipe(s) (96) in the first direction.

3. The heat dissipation device of claim 2, wherein the first fin inner edgefold (922) is formed on part of the first heat dissipation fin (920) in a length direction of the heat pipe(s) (96).

4. The heat dissipation device of claim 2 or 3, wherein the first fin inner edgefold (922) contacts adjacent heat dissipation fin in the fin group (90).

5. The heat dissipation device of any one of claims 2 to 4, wherein the first heat dissipation fin (920) further includes a first fin outer edgefold (923), wherein the first fin outer edgefold (923) and the first fin inner edgefold (922) are located at two ends of the first fin body (921) in the first direction.

6. The heat dissipation device of any one of claims 1 to 5, wherein the heat dissipation fins further include a second heat dissipation fin (910), wherein the second heat dissipation fin (910) and the first heat dissipation fin (920) form a whole structure, and the second heat dissipation fin (910) contacts the heat pipe(s) (96) on one side of the heat pipe(s) (96) in the first direction.

7. The heat dissipation device of claim 6, wherein the second heat dissipation fin (910) includes a second fin body (911) and a second fin inner edgefold (912), wherein the second fin inner edgefold (912) is bent from the second fin body (911) and contacts the heat pipe(s) (96) in the first direction.

8. The heat dissipation device of claim 7, wherein the second fin inner edgefold (912) contacts adjacent heat dissipation fin in the fin group (90).

9. The heat dissipation device of claim 7 or 8, wherein the second heat dissipation fin (910) further includes a second fin outer edgefold (913), the second fin outer edgefold (913) and the second fin inner edgefold (912) are located at two ends of the second fin body (911) in the first direction.

10. The heat dissipation device of any one of claims 1 to 9, wherein the heat pipe(s) (96) is a flattened heat pipe(s) (96), and the flattening direction of the flattened heat pipe(s) (96) is the first direction.

11. The heat dissipation device of any one of claims 1 to 10, wherein the heat dissipation device further includes a metal heat dissipation plate (95), wherein the metal heat dissipation plate (95) is located on the other side of the heat pipe group (960) in the first direction, and the metal heat dissipation plate (95) contacts the heat pipe(s) (96).

12. The heat dissipation device of claim 11, wherein the heat dissipation fins, the heat pipe group (960) and the metal heat dissipation plate (95) are joined together by reflow soldering.

13. A board card, comprising the heat dissipation device of any one of claims 1 to 12.

## Patentansprüche

1. Wärmeableitungsvorrichtung, umfassend:
eine Rippengruppe (90), die eine Vielzahl von Wärmeableitungsrippen beinhaltet, die eine Gesamtstruktur bilden; und
eine Wärmerohrgruppe (960), die eine Vielzahl von Wärmerohren (96) beinhaltet,
wobei die Rippengruppe (90) im Wesentlichen auf einer Seite der Wärmerohrgruppe (960) in einer ersten Richtung angeordnet ist, die Rippengruppe (90) die Wärmerohrgruppe (960) in der ersten Richtung kontaktiert, die Wärmeableitungsrippen eine erste Wärmeableitungsrippe (920) beinhalten, die zumindest eines aus der Vielzahl von Wärmerohren (96) in einer zweiten Richtung kontaktiert, um zumindest eines aus der Vielzahl von Wärmerohren (96) in der zweiten Richtung anzuordnen,
**dadurch gekennzeichnet, dass**
die Vielzahl von Wärmerohren parallel in der zweiten Richtung vorgesehen ist und die Vielzahl von Wärmeableitungsrippen parallel in der zweiten Richtung vorgesehen ist.

2. Wärmeableitungsvorrichtung nach Anspruch 1, wobei die erste Wärmeableitungsrippe (920) einen ersten Rippenkörper (921) und eine erste Rippeninnenkantenfaltung (922) beinhaltet, wobei der erste Rippenkörper (921) das/die Wärmerohr(e) (96) in der zweiten Richtung kontaktiert, die erste Rippeninnenkantenfaltung (922) winklig von dem ersten Rippenkörper (921) vorsteht, und die erste Rippeninnenkantenfaltung (922) das/die Wärmerohr(e) (96) auf einer Seite des/der Wärmerohre(s) (96) in der ersten Richtung kontaktiert.

3. Wärmeableitungsvorrichtung nach Anspruch 2, wobei die erste Rippeninnenkantenfaltung (922) an Teil der ersten Wärmeableitungsrippe (920) in einer Längsrichtung des/der Wärmerohre(s) (96) gebildet ist.

4. Wärmeableitungsvorrichtung nach Anspruch 2 oder 3, wobei die erste Rippeninnenkantenfaltung (922) benachbarte Wärmeableitungsrippen in der Rippengruppe (90) kontaktiert.

5. Wärmeableitungsvorrichtung nach einem der Ansprüche 2 bis 4, wobei die erste Wärmeableitungsrippe (920) ferner eine erste Rippenaußenkantenfaltung (923) beinhaltet, wobei die erste Rippenaußenkantenfaltung (923) und die erste Rippeninnenkantenfaltung (922) an zwei Enden des ersten Rippenkörpers (921) in der ersten Richtung angeordnet sind.

6. Wärmeableitungsvorrichtung nach einem der Ansprüche 1 bis 5, wobei die Wärmeableitungsrippen ferner eine zweite Wärmeableitungsrippe (910) beinhalten, wobei die zweite Wärmeableitungsrippe (910) und die erste Wärmeableitungsrippe (920) eine Gesamtstruktur bilden, und die zweite Wärmeableitungsrippe (910) das/die Wärmerohr(e) (96) auf einer Seite des/der Wärmerohre(s) (96) in der ersten Richtung kontaktiert.

7. Wärmeableitungsvorrichtung nach Anspruch 6, wobei die zweite Wärmeableitungsrippe (910) einen zweiten Rippenkörper (911) und eine zweite Rippeninnenkantenfaltung (912) beinhaltet, wobei die zweite Rippeninnenkantenfaltung (912) von dem zweiten Rippenkörper (911) gebogen ist und das/die Wärmerohr(e) (96) in der ersten Richtung kontaktiert.

8. Wärmeableitungsvorrichtung nach Anspruch 7, wobei die zweite Rippeninnenkantenfaltung (912) benachbarte Wärmeableitungsrippe in der Rippengruppe (90) kontaktiert.

9. Wärmeableitungsvorrichtung nach Anspruch 7 oder 8, wobei die zweite Wärmeableitungsrippe (910) ferner eine zweite Rippenaußenkantenfaltung (913) beinhaltet, wobei die zweite Rippenaußenkantenfaltung (913) und die zweite Rippeninnenkantenfaltung (912) an zwei Enden des zweiten Rippenkörpers (911) in der ersten Richtung angeordnet sind.

10. Wärmeableitungsvorrichtung nach einem der Ansprüche 1 bis 9, wobei das/die Wärmerohr(e) (96) ein abgeflachte(s) Wärmerohr(e) (96) ist und die Abflachungsrichtung des/der abgeflachten Wärmerohre(s) (96) die erste Richtung ist.

11. Wärmeableitungsvorrichtung nach einem der Ansprüche 1 bis 10, wobei die Wärmeableitungsvorrichtung ferner eine Metallwärmeableitungsplatte (95) beinhaltet, wobei die Metallwärmeableitungsplatte (95) auf der anderen Seite der Wärmerohrgruppe (960) in der ersten Richtung angeordnet ist und die Metallwärmeableitungsplatte (95) das/die Wärmerohr(e) (96) kontaktiert.

12. Wärmeableitungsvorrichtung nach Anspruch 11, wobei die Wärmeableitungsrippen, die Wärmerohrgruppe (960) und die Metallwärmeableitungsplatte (95) durch Reflow-Löten miteinander verbunden sind.

13. Leiterplatte, umfassend die Wärmeableitungsvorrichtung nach einem der Ansprüche 1 bis 12.

## Revendications

1. Dispositif de dissipation de chaleur, comprenant :
un groupe d'ailettes (90) comprenant une pluralité d'ailettes de dissipation de chaleur qui forment une structure entière; et
un groupe de caloducs (960) comprenant une pluralité de caloducs (96),
ledit groupe d'ailettes (90) étant sensiblement situé sur un côté du groupe de caloducs (960) dans une première direction, ledit groupe d'ailettes (90) entrant en contact avec le groupe de caloducs (960) dans la première direction, lesdites ailettes de dissipation de chaleur comprenant une première ailette de dissipation de chaleur (920) qui entre en contact avec au moins l'un de la pluralité de caloducs (96) dans une seconde direction de façon à localiser au moins l'un de la pluralité de caloducs (96) dans la seconde direction,
**caractérisé en ce que**
la pluralité de caloducs sont agencés parallèlement dans la seconde direction, et la pluralité d'ailettes de dissipation de chaleur sont agencées parallèlement dans la seconde direction.

2. Dispositif de dissipation de chaleur selon la revendication 1, ladite première ailette de dissipation de chaleur (920) comprenant un corps de première ailette (921) et un pli de bord interne de première ailette (922), ledit corps de première ailette (921) entrant en contact avec le ou les caloduc(s) (96) dans la seconde direction, le pli de bord interne de première ailette (922) faisant saillie de manière oblique à partir du corps de première ailette (921), et ledit pli de bord interne de première ailette (922) entrant en contact avec le ou les caloduc(s) (96) sur un côté du ou des caloduc(s) (96) dans la première direction.

3. Dispositif de dissipation de chaleur selon la revendication 2, ledit pli de bord interne de première ailette (922) étant formé sur une partie de la première ailette de dissipation de chaleur (920) dans une direction longitudinale du ou des caloduc(s) (96).

4. Dispositif de dissipation de chaleur selon la revendication 2 ou 3, ledit pli de bord interne de première ailette (922) entrant en contact avec une ailette de dissipation de chaleur adjacente dans le groupe d'ailettes (90).

5. Dispositif de dissipation de chaleur selon l'une quelconque des revendications 2 à 4, ladite première ailette de dissipation de chaleur (920) comprenant en outre un pli de bord externe de première ailette (923), ledit pli de bord externe de première ailette (923) et ledit pli de bord interne de première ailette (922) étant situés au niveau de deux extrémités du corps de première ailette (921) dans la première direction.

6. Dispositif de dissipation de chaleur selon l'une quelconque des revendications 1 à 5, lesdites ailettes de dissipation de chaleur comprenant en outre une seconde ailette de dissipation de chaleur (910), ladite seconde ailette de dissipation de chaleur (910) et ladite première ailette de dissipation de chaleur (920) formant une structure entière, et ladite seconde ailette de dissipation de chaleur (910) entrant en contact avec le ou les caloduc(s) (96) sur un côté du ou des caloduc(s) (96) dans la première direction.

7. Dispositif de dissipation de chaleur selon la revendication 6, ladite seconde ailette de dissipation de chaleur (910) comprenant un corps de seconde ailette (911) et un pli de bord interne de seconde ailette (912), ledit pli de bord interne de seconde ailette (912) étant courbé à partir du corps de seconde ailette (911) et entrant en contact avec le ou les caloduc(s) (96) dans la première direction.

8. Dispositif de dissipation de chaleur selon la revendication 7, ledit pli de bord interne de seconde ailette (912) entrant en contact avec une ailette de dissipation de chaleur adjacente dans le groupe d'ailettes (90).

9. Dispositif de dissipation de chaleur selon la revendication 7 ou 8, ladite seconde ailette de dissipation de chaleur (910) comprenant en outre un pli de bord externe de seconde ailette (913), ledit pli de bord externe de seconde ailette (913) et ledit pli de bord interne de seconde ailette (912) étant situés au niveau de deux extrémités du corps de seconde ailette (911) dans la première direction.

10. Dispositif de dissipation de chaleur selon l'une quelconque des revendications 1 à 9, ledit ou lesdits caloduc(s) (96) étant un ou des caloduc(s) aplatis (96), et ladite direction d'aplatissement du ou des caloduc(s) aplatis (96) étant la première direction.

11. Dispositif de dissipation de chaleur selon l'une quelconque des revendications 1 à 10, ledit dispositif de dissipation de chaleur comprenant en outre une plaque de dissipation de chaleur métallique (95), ladite plaque de dissipation de chaleur métallique (95) étant située de l'autre côté du groupe de caloducs (960) dans la première direction, et ladite plaque de dissipation de chaleur métallique (95) entrant en contact avec le ou les caloduc(s) (96).

12. Dispositif de dissipation de chaleur selon la revendication 11, lesdites ailettes de dissipation de chaleur, ledit groupe de caloducs (960) et ladite plaque de dissipation de chaleur métallique (95) étant assemblés par soudage par refusion.

13. Carte de circuit, comprenant le dispositif de dissipation de chaleur selon l'une quelconque des revendications 1 à 12.
